# EUROPEAN PATENT APPLICATION

(11) **EP 4 718 066 A1**
(43) Date of publication of application: **01.04.2026**
(21) Application number: 25199542.9
(22) Date of filing: 02.09.2025
(51) Int. Cl.: G01N 25/72, G11C 29/04, G11C 29/44, G11C 29/56, H10W 20/43, G06T 7/00, G11C 29/50

(54) **METHODS AND APPARATUS TO IMPROVE INSPECTION TECHNIQUES FOR INTEGRATED CIRCUITS WITH BACKSIDE POWER DELIVERY**

(30) Priority: 25.09.2024 US 202418896199
(71) Applicant: INTEL Corporation, Santa Clara, CA 95054 (US)
(72) Inventor: POSADA ARBELAEZ, Chrystian Mauricio, PORTLAND, 97210 (US); KHOO, Grace Mei Ee, Portland, 97229 (US); SENEVIRATHNA, Bathiya Prashan Bandara, Hillsboro, 97124 (US); NGUYEN, Binh, Cupertino, 95014 (US)
(74) Representative: 2SPL Patentanwälte PartG mbB

(57) **Abstract**

Systems, apparatus, articles of manufacture, and methods are disclosed to improve inspection techniques for integrated circuits with backside power delivery. An example disclosed apparatus includes at least one programmable circuit to at least one of instantiate or execute the machine readable instructions to modulate first and second bitlines for a bitcell in a memory array of an integrated circuit between first and second voltages at a frequency for a period of time, the modulating of the first and second bitlines to produce a periodic heat signal in the integrated circuit, cause a thermal imaging sensor to capture a series of images of the integrated circuit during the period of time, and determine a location of a defect in the integrated circuit based on the series of images.

## Description

### BACKGROUND

Semiconductor testing, debugging, or failure analysis is performed on integrated circuits (ICs) to identify physical defects or electrical anomalies within ICs. To identify the root cause of a defect it is helpful to pinpoint the specific location and/or the nature of the defect. ICs can have conventional front side power delivery where the IC is constructed with transistors at the surface of the silicon and all interconnects that power the transistors and transmit their data signals are built above the transistors. Alternatively, ICs can have backside power delivery where data interconnects are built above the transistors and the power-delivering interconnects are built beneath (e.g., through) the silicon on which the transistors are built.

### BRIEF DESCRIPTION OF THE DRAWINGS

FIG. 1 is a top view of a wafer including dies that may be included in an integrated circuit (IC) package constructed in accordance with teachings disclosed herein.
FIG. 2 is a cross-sectional side view of an IC device that may be included in an IC package constructed in accordance with teachings disclosed herein.
FIG. 3 is a block diagram of an example environment in which example defect detection circuitry operates to achieve single bit resolution imaging of static random access memory (SRAM) cells on an IC with backside power delivery to detect defects in an IC.
FIG. 4 illustrates the example six transistor (6T) SRAM cell of FIG. 3 in an initial state.
FIG. 5 illustrates the example 6T SRAM cell of FIGS. 3 and 4 in a second state during a data collection phase.
FIG. 6 is a block diagram of an example implementation of the defect detection circuitry of FIG. 3.
FIGS. 7-9 are flowcharts representative of example machine readable instructions and/or example operations that may be executed, instantiated, and/or performed by example programmable circuitry to implement the example defect detection circuitry of FIG. 6.
FIG. 10 is a block diagram of an example processing platform including programmable circuitry structured to execute, instantiate, and/or perform the example machine readable instructions and/or perform the example operations of FIGS. 7-9 to implement the defect detection apparatus 302 of FIG. 6.
FIG. 11 is a block diagram of an example implementation of the programmable circuitry of FIG. 10.
FIG. 12 is a block diagram of another example implementation of the programmable circuitry of FIG. 10.

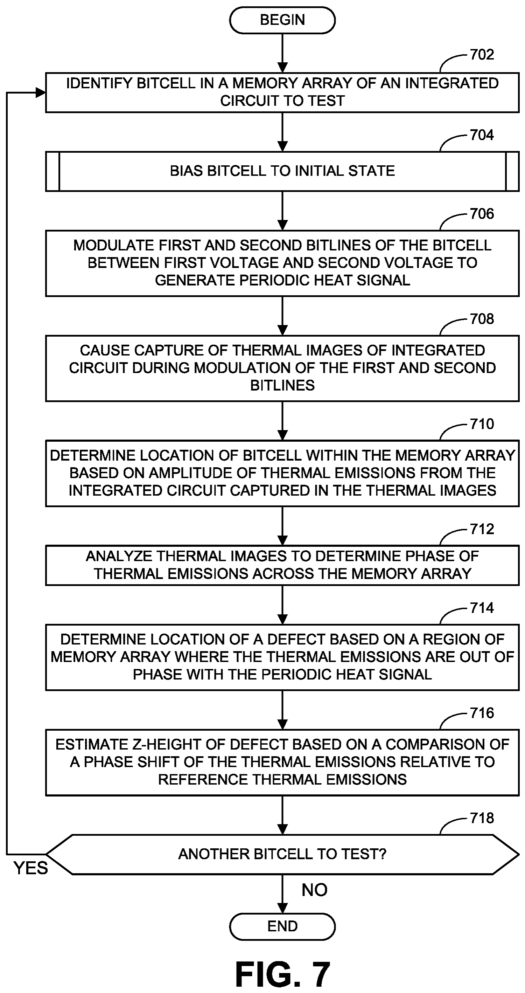

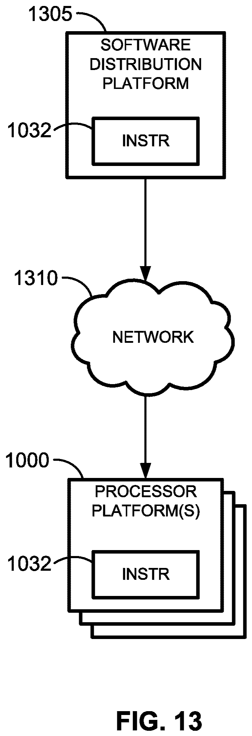

FIG. 13 is a block diagram of an example software/firmware/instructions distribution platform (e.g., one or more servers) to distribute software, instructions, and/or firmware (e.g., corresponding to the example machine readable instructions of FIGS. 7-9) to client devices associated with end users and/or consumers (e.g., for license, sale, and/or use), retailers (e.g., for sale, re-sale, license, and/or sub-license), and/or original equipment manufacturers (OEMs) (e.g., for inclusion in products to be distributed to, for example, retailers and/or to other end users such as direct buy customers).

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

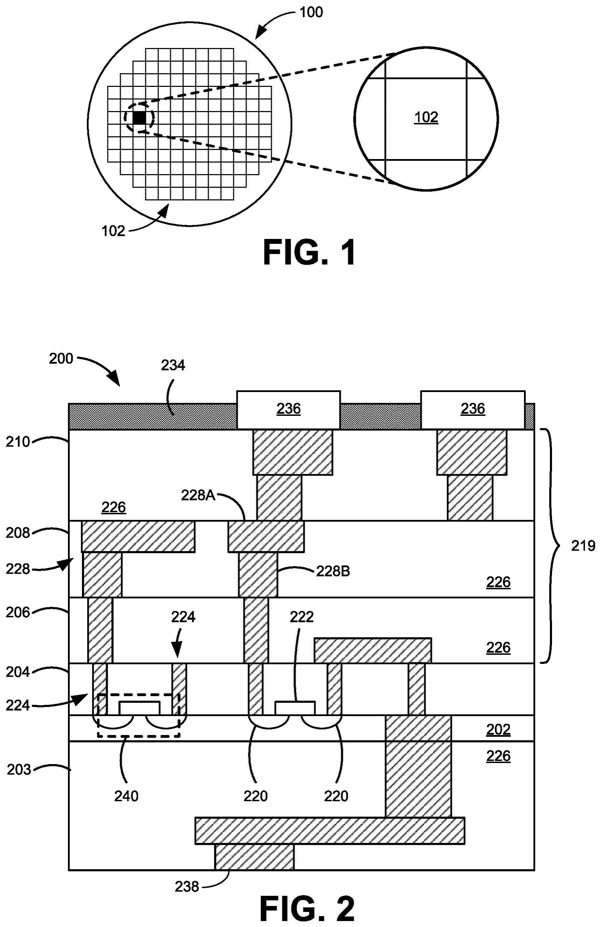

FIGS. 1-2 illustrate various example integrated circuits (ICs) that may be inspected using the defect detection circuitry disclosed herein. ICs with frontside power delivery architectures can be inspected for defects using the conventional approach of optical fault isolation (OFI). OFI is a technique used in electronic systems to isolate faults or defects by utilizing optical signals. However, an IC with a backside power delivery architecture has metal stacks on either side of the active transistor layer. This layout blocks optical access to the transistor layers that conventional OFI techniques are used to access. Alternative techniques to detect defects include capturing emissions in the form of thermal radiation originated at the defect location, as in the case of lock-in thermography (LIT) or direct probing of signals using electron beams (EBP). However, these solutions are limited in terms of spatial resolution or signal access. For example, EBP is hindered by the limited penetration depth of the electron beams or the restricted access to signals of interest using the topmost metal layers. The resolution in LIT is compromised by the longer wavelengths (e.g., 2.5 micrometer (µm) to 5 µm) in which the thermal cameras operate. LIT results are also compromised by the intrinsic thermal spread as heat propagates across the multiple interconnect layers between the defect and the device surface.

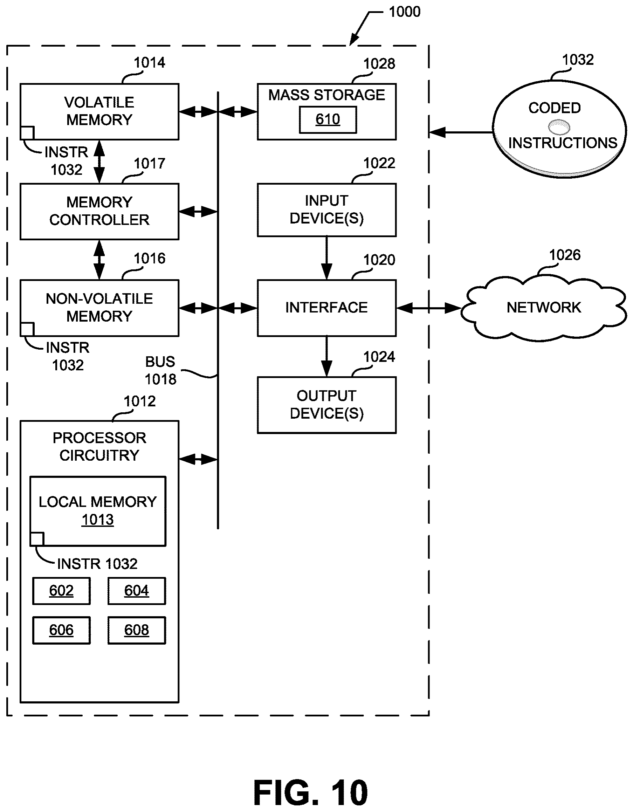

FIG. 1 is a top view of a wafer 100 including dies 102 that may be included in an integrated circuit (IC) package that is to be inspected for fault isolation (e.g., inspected for defects) in accordance with teachings disclosed herein. As discussed further below in connection with FIG. 2, the dies 102 include backside power delivery architectures. As such, there are significant limitations in the ability to inspect such dies 102 for defects as noted above. In the illustrated example of FIG. 1, the wafer 100 includes semiconductor material and one or more dies 102 having circuitry. Each of the dies 102 may be a repeating unit of a semiconductor product. After the fabrication of the semiconductor product is complete, the wafer 100 may undergo a singulation process in which the dies 102 are separated from one another to provide discrete "chips." The die 102 includes one or more transistors (e.g., some of the transistors 240 of FIG. 2, discussed below), supporting circuitry to route electrical signals to the transistors, passive components (e.g., traces, resistors, capacitors, inductors, and/or other circuitry), and/or any other components. In some examples, the die 102 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry or electronics. Multiple ones of these devices may be combined on a single die 102. For example, a memory array of multiple memory circuits may be formed on a same die 102 as programmable circuitry (e.g., the processor circuitry 1012 of FIG. 10) and/or other logic circuitry. Such memory may store information for use by the programmable circuitry.

FIG. 2 is a cross-sectional side view of an IC device 200 that may be included in one or more dies 102 (FIG. 1) that are to be inspected for fault isolation in accordance with teachings disclosed herein. The IC device 200 may be formed on a die substrate 202 (e.g., the wafer 100 of FIG. 1) and may be included in a die (e.g., the die 102 of FIG. 1). The die substrate 202 may be a semiconductor substrate including semiconductor materials including, for example, n-type or p-type materials systems (or a combination of both). The die substrate 202 may include, for example, a crystalline substrate formed using a bulk silicon or a silicon-on-insulator (SOI) substructure. In some examples, the die substrate 202 may be formed using alternative materials, which may or may not be combined with silicon, that include but are not limited to germanium, indium antimonide, lead telluride, indium arsenide, indium phosphide, gallium arsenide, or gallium antimonide. Further materials classified as groups II-VI, III-V, or IV may also be used to form the die substrate 202. Although a few examples of materials from which the die substrate 202 may be formed are described here, any material that may serve as a foundation for an IC device 200 may be used. The die substrate 202 may be part of a singulated die (e.g., the dies 102 of FIG. 1) or a wafer (e.g., the wafer 100 of FIG. 1).

The IC device 200 may include one or more device layers 204 disposed on and/or above the die substrate 202. The backside of the die substrate 202 may include a backside power delivery layer 203. The power delivery layer 203 may include a dielectric material 226. The device layer 204 may include features of one or more transistors 240 (e.g., metal oxide semiconductor field-effect transistors (MOSFETs)) formed on the die substrate 202. The device layer 204 may include, for example, one or more source and/or drain (S/D) regions 220, a gate 222 to control current flow between the S/D regions 220, and one or more S/D contacts 224 to route electrical signals to/from the S/D regions 220. The transistors 240 may include additional features not depicted for the sake of clarity, such as device isolation regions, gate contacts, and the like. The transistors 040 are not limited to the type and configuration depicted in FIG. 2 and may include a wide variety of other types and/or configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 240 may include a gate 222 including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and/or zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and/or lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 240 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included, such as a barrier layer. For a PMOS transistor, metals that may be used for the gate electrode include, but are not limited to, ruthenium, palladium, platinum, cobalt, nickel, conductive metal oxides (e.g., ruthenium oxide), and/or any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and/or aluminum carbide), and/or any of the metals discussed above with reference to a PMOS transistor (e.g., for work function tuning).

In some examples, when viewed as a cross-section of the transistor 240 along the source-channel-drain direction, the gate electrode may include a U-shaped structure that includes a bottom portion substantially parallel to the surface of the die substrate 202 and two sidewall portions that are substantially perpendicular to the top surface of the die substrate 202. In other examples, at least one of the metal layers that form the gate electrode may be a planar layer that is substantially parallel to the top surface of the die substrate 200 and does not include sidewall portions substantially perpendicular to the top surface of the die substrate 202. In other examples, the gate electrode may include a combination of U-shaped structures and/or planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and/or silicon oxynitride. Processes for forming sidewall spacers are well known in the art and generally include deposition and etching process operations. In some examples, a plurality of spacer pairs may be used; for instance, two pairs, three pairs, or four pairs of sidewall spacers may be formed on opposing sides of the gate stack.

The S/D regions 220 may be formed within the die substrate 202 adjacent to the gate 222 of corresponding transistor(s) 240. The S/D regions 220 may be formed using an implantation/diffusion process or an etching/deposition process, for example. In the former process, dopants such as boron, aluminum, antimony, phosphorous, or arsenic may be ion-implanted into the die substrate 202 to form the S/D regions 220. An annealing process that activates the dopants and causes them to diffuse farther into the die substrate 202 may follow the ion-implantation process. In the latter process, the die substrate 202 may first be etched to form recesses at the locations of the S/D regions 220. An epitaxial deposition process may then be carried out to fill the recesses with material that is used to fabricate the S/D regions 220. In some implementations, the S/D regions 220 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 220 may be formed using one or more alternate semiconductor materials such as germanium or a group III-V material or alloy. In further examples, one or more layers of metal and/or metal alloys may be used to form the S/D regions 220.

Electrical signals, such input/output (I/O) signals, may be routed to and/or from the devices (e.g., transistors 240) of the device layer 204 through one or more interconnect layers disposed on the device layer 204 (illustrated in FIG. 2 as interconnect layers 06-210). For example, electrically conductive features of the device layer 204 (e.g., the gate 222 and the S/D contacts 224) may be electrically coupled with the interconnect structures 228 of the interconnect layers 206-210. The one or more interconnect layers 206-210 may form a metallization stack (also referred to as an "ILD stack") 219 of the IC device 200.

The interconnect structures 228 may be arranged within the interconnect layers 206-210 to route electrical signals according to a wide variety of designs (in particular, the arrangement is not limited to the particular configuration of interconnect structures 228 depicted in FIG. 2). Although a particular number of interconnect layers 206-210 is depicted in FIG. 2, examples of the present disclosure include IC devices having more or fewer interconnect layers than depicted.

In some examples, the interconnect structures 228 may include lines 228a and/or vias 228b filled with an electrically conductive material such as a metal. The lines 228a may be arranged to route electrical signals in a direction of a plane that is substantially parallel with a surface of the die substrate 202 upon which the device layer 204 is formed. For example, the lines 228a may route electrical signals in a direction in and/or out of the page from the perspective of FIG. 2. The vias 228b may be arranged to route electrical signals in a direction of a plane that is substantially perpendicular to the surface of the die substrate 202 upon which the device layer 204 is formed. In some examples, the vias 228b may electrically couple lines 228a of different interconnect layers 206-210 together.

The interconnect layers 206-210 may include a dielectric material 226 disposed between the interconnect structures 228, as shown in FIG. 2. In some examples, the dielectric material 226 disposed between the interconnect structures 228 in different ones of the interconnect layers 206-210 may have different compositions; in other examples, the composition of the dielectric material 226 between different interconnect layers 206-210 may be the same.

A first interconnect layer 206 (referred to as Metal 1) may be formed directly on the device layer 204. In some examples, the first interconnect layer 206 may include lines 228a and/or vias 228b, as shown. The lines 228a of the first interconnect layer 206 may be coupled with contacts (e.g., the S/D contacts 224) of the device layer 204.

A second interconnect layer 208 (referred to as Metal 2) may be formed directly on the first interconnect layer 206. In some examples, the second interconnect layer 208 may include vias 228b to couple the lines 228a of the second interconnect layer 208 with the lines 228a of the first interconnect layer 206. Although the lines 228a and the vias 228b are structurally delineated with a line within each interconnect layer (e.g., within the second interconnect layer 208) for the sake of clarity, the lines 228a and the vias 228b may be structurally and/or materially contiguous (e.g., simultaneously filled during a dual-damascene process) in some examples.

A third interconnect layer 210 (referred to as Metal 3) (and additional interconnect layers, as desired) may be formed in succession on the second interconnect layer 208 according to similar techniques and/or configurations described in connection with the second interconnect layer 208 or the first interconnect layer 206. In some examples, the interconnect layers that are "higher up" in the metallization stack 219 in the IC device 200 (i.e., further away from the device layer 204) may be thicker.

The IC device 200 may include a solder resist material 234 (e.g., polyimide or similar material) and one or more conductive contacts 236 formed on the interconnect layers 206-210. In FIG. 2, the conductive contacts 236 are illustrated as taking the form of bond pads. The conductive contacts 236 may be electrically coupled with the interconnect structures 228 and configured to route the electrical signals of the transistor(s) 240 to other external devices. For example, solder bonds may be formed on the one or more conductive contacts 236 to mechanically and/or electrically couple a chip including the IC device 200 with another component (e.g., a circuit board). The IC device 200 may include additional or alternate structures to route the electrical signals from the interconnect layers 206-210; for example, the conductive contacts 236 may include other analogous features (e.g., posts) that route the electrical signals to external components.

In the illustrated example of FIG. 2, the IC device 200 includes a backside power delivery system. The backside power delivery system may include one or more through-silicon vias (TSVs) 238 that extend through substrate 202 and/or the backside power delivery layer 203 to a backside of the IC device 200. In some examples, the backside power delivery layer 203 includes multiple layers of the dielectric material 226 with corresponding layers of metal that interconnect the TSVs 238 in a manner similar to the interconnect layers 206-210 with the associated interconnect structures 228. In some examples, the TSVs 238 deliver power to the device layer 204. In some examples, the TSVs 238 can be formed of a conductive material, such as copper, cobalt, tungsten, aluminum, any other suitable conductive material, and/or combinations thereof. Backside power delivery systems move some or all the power-delivering interconnects to beneath the silicon on which the transistors are built. This leaves more space for the data interconnects above the silicon and the power interconnects can be made larger and therefore less resistive. The IC device 200 with backside power delivery has signal and power wires placed on either side of the transistor layer, obstructing access to the transistor layer via conventional optical fault isolation (OFI) techniques. Consequently, a technique capable of imaging through metal layers and other materials that are opaque in the near and mid-infrared (IR) range is required to debug an IC with backside power delivery system. However, as discussed above, some such techniques are limited to relatively low resolution due to the longer wavelengths (e.g., 2.5 micrometer (µm) to 5 µm) in which the thermal cameras operate. More particularly, existing lock-in thermography (LIT) techniques have a resolution of around 2 µm is almost an order of magnitude worse than the resolution achievable using OFI techniques (useful when inspecting ICs that include frontside power delivery but not backside power delivery). Examples disclosed herein enable the inspection of ICs with backside power delivery architectures with a resolution of around 200 nanometers (nm).

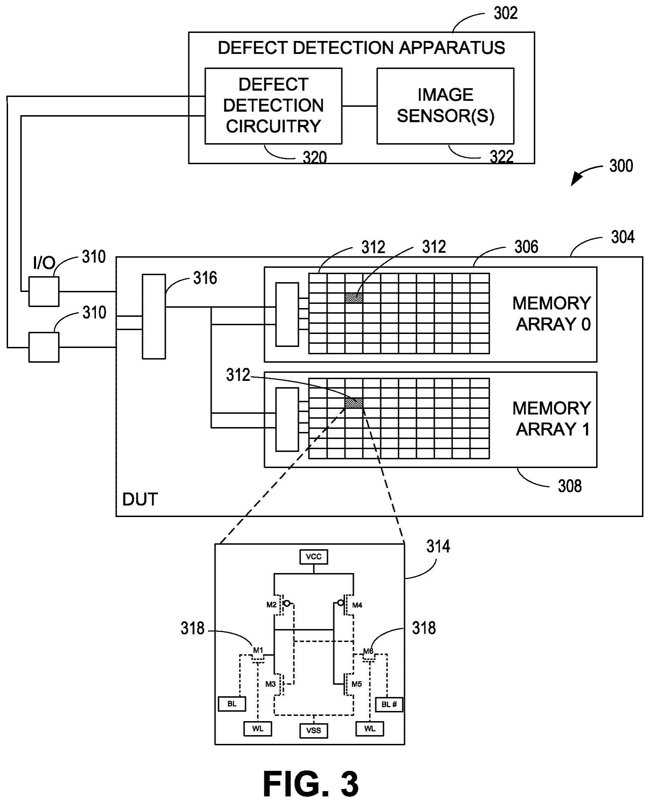

FIG. 3 is a block diagram of an example environment in which an example defect detection apparatus 302 is to implement inspection techniques to detect defect(s) in an example device under test (DUT) 304 corresponding to the example IC device 200 of FIG. 2 (e.g., an IC device with backside power delivery) and/or an array of such devices (e.g., the full wafer 100 of dies 102 of FIG. 1). In this example, the DUT 304 corresponds to a static random-access memory (SRAM) memory chip that includes an example first memory array 306 (e.g., memory array 0), example second memory array 308 (e.g., memory array 1), and example control logic 316. The example DUT 304 is connected to external pads or input output ports 310 that are communicatively coupled to the defect detection apparatus 302. In this example, the memory arrays 306, 308 include a plurality of example six transistor (6T) SRAM cell 312. An example exploded view 314 of one of the 6T SRAM cells 312 shows the example electrical layout of the six individual transistors labelled as M1, M2, M3, M4. M5, and M6 in the exploded view 314. The defect detection apparatus 302 includes example defect detection circuitry 320 and one or more example image sensor(s) 322. The defect detection circuitry 320 communicates with the DUT 304 to control operation of the memory arrays 306, 308 while also communicating with the image sensor(s) 322 to capture and obtain and analyze images of the DUT 304 for defect detection.

While the illustrated example of FIG. 3 involves the defect detection apparatus 302 analyzing arrays of 6T SRAM cells 312 within a SRAM memory chip, examples disclosed herein can be used for other types of ICs. In some examples, the defect detection apparatus 302 can be used to inspect defects in other array types, such as register file (RF) arrays. Further, examples disclosed herein (which involve inducing emissions by creating a contention structure) can be used not only in such arrays, but also in other logic devices such as logic gates, flip-flops, multiplexers, registers, microcontrollers, arithmetic logic units (ALU) or any other logic devices.

FIG. 3 illustrates a test mode architecture with access ports of an individual SRAM bitcell 312 routed to an external pad (e.g., input output (IO) ports 310) via the example control logic 316. The example DUT 304 which includes the first memory array 306, and the second memory array 308 is tested with a high-speed alternating current (AC) raster test method. The AC raster test involves writing binary values to individual bitcells in the memory array 306, 308 and reading back the binary values from the individual bitcells 312. The test operates at high speeds to quickly test different memory locations and verify their integrity. If a bitcell 312 fails the AC raster test, a test mode architecture is used for defect classification. Defect classification helps analyze root cause of a failure on an IC chip. Test mode is an additional test architecture where access ports of each bit are multiplexed and routed out to an example defect detection apparatus 302.

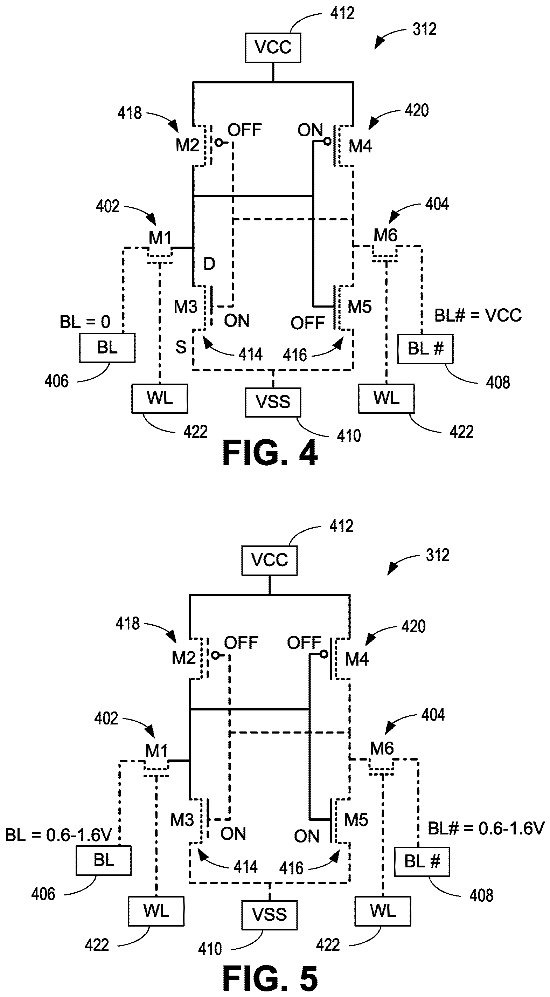

The multiplexing is performed by using analog pass gates (e.g., the two transistors identified by reference number 318 in FIG. 3). The defect detection apparatus 302 is used to drive an analog voltage bias into individual bitcells 312, which is described in detail below in connection with FIG. 4. The test mode architecture provides electrical current and voltage measurements on bitcells that failed the raster tests. Driving voltage into individual bitcell 312 creates a thermal emission or a heatwave signal that is captured using lock-in thermography (LIT). The testing method disclosed herein detects thermal emissions from a single bitcell that has approximately 200 nanometer (nm) width. Thus, the resolution of defect detection techniques disclosed herein is around 200 nm. In some examples, the test mode architecture is implemented on the largest array in the chip, such as last level cache data (LLCDAT) and level 2 cache data (L2DAT). LLCDAT sizes range from a few megabytes (MB) to several tens of megabytes. L2DAT sizes range from a few megabytes.

The examples disclosed herein provide a precise testing method for performing logic-to-physical (L2P) validation of memory arrays. L2P validation is the process of taking a logical design address of a memory bitcell within an IC chip and validating its precise physical location on a manufactured silicon part. The examples disclosed herein also provide a flexible alternative for generating reference emissions within complex memory arrays. Using LIT, the phase-shift values of a reference emission can be used to compare against the phase-shift values of an emission generated by defects to estimate the depth (e.g., z-height) of the defect in the metal stack. Examples disclosed herein provide a quick alternative to infer whether a defect is located in the top or back metal layers of a backside power delivery architecture. The test mode architecture described herein enables intentional generation of thermal emission across the DUT 304, which can serve as reference emissions originated at the transistor layer. Access to these reference emissions emitted from the transistor level is important to infer the size and estimated vertical location of defects in the metal stack.

FIG. 4 illustrates the example 6T SRAM cell 312 of FIG. 3 in an initial state. In the illustrated example of FIG. 4, a low yield analysis (LYA) test mode is employed to identify faulty SRAM cells. The defect detection apparatus 302 (FIG. 3) selects and biases the single 6T SRAM cell to an initial state. The example 6T SRAM cell 312 includes an example first pass gate transistor (M1) 402, an example second pass gate transistor (M6) 404, an example first N-channel transistor (M3) 414, an example second N-channel transistor (M5) 416, an example first P-channel transistor (M2) 418, and an example second P-channel transistor (M4) 420. As shown in the illustrated example, the first pass gate transistor (M1) 402 is electrically coupled to an example bitline (BL) 406 and controlled by an example wordline (WL) 422. The second pass gate transistor (M6) 404 is electrically coupled to an example bitline complement (BL#) 408, and also controlled by the example wordline (WL) 422. Further, the first N-channel transistor (M3) 414 and the second N-channel transistor (M5) 416 are electrically coupled to an example reference voltage level (Vss) 410, while the first P-channel transistor (M2) 418 and the second P-channel transistor (M4) 420 are electrically coupled to an example supply voltage (Vcc) 412.

In the illustrated example, the SRAM cell 312 is biased to an initial state by holding the pass gate transistors (M1) 402 and (M6) 404 in a constant 'on' state by turning the WL 422 'on'. The 6T SRAM cell 312 is pre-conditioned to a logic 0 state by holding BL 406 at Vss = 0V, and BL# 408 at Vcc = 0.6V. Holding the 6T SRAM cell 312 in this state renders the first N-channel transistor (M3) 414 'on' and first P-channel transistor (M2) 418 'off' while the second N-channel transistor (M5) 416 is "off" and the second P-channel transistor (M4) 420 is 'on'. Since there is little potential difference between source and drain of M3 414 in this initial state, the current flow through the channel on M3 414 is negligible. The SRAM cell 312 is set to an initial state to evaluate the response and characteristics under different conditions.

FIG. 5 illustrates the 6T SRAM cell 312 of FIGS. 3 and 4 in a second state during a data collection phase. During the data collection phase, BL 406 and BL# 408 are modulated concurrently between different voltages at a particular frequency. In some examples, the voltage modulates between 0.6V and 1.6V at a frequency of 100 Hz. However, different voltages and/or different frequencies may also be used. When the voltage is modulated, current flows through M3 414 and M5 416 due to an increase in potential difference between BL 406 or BL# 408 and Vss 410. When the voltage is modulated between 0.6V to 1.1V, the current measured at BL 406 or BL# 408 is minimum (e.g., between 0 milliampere (mA) to 2 mA). When the voltage is modulated between 1.1V to 1.6V, the current measured at BL 406 or BL# 408 increases to approximately 12mA. Modulating BL 406 and BL# 408 between 0.6V to 1.6V creates a periodic heatwave in the device layer. This periodic modulation is measured using a photon detector (e.g., the image sensor(s) 322 of FIG. 3) sensitive to mid-infrared (IR) photons (e.g., 2.5 micrometer (µm) to 5µm). For improved signal-to-noise (SNR) ratio, the periodic thermal signal generated by the SRAM cell 312 is captured in a time sequence, and a lock-in amplification process is used to extract phase and amplitude of the thermal signal. A lock-in amplification process is used in signal processing to extract a small signal from a noisy background. Thermal emissions pinpointing the precise location of faulty bitcells can be observed using a lock-in thermography. Experimental testing has validated the above process to enable the capture of thermal emissions for BL 406 and BL# 408 modulated between 0.6V to 1.6V in an SRAM bitcells in backside powered IC units both with a short stack (e.g., six top metal layers) and a full stack (e.g., 14 top metal layers).

An important factor for successful bitcell imaging is modulating both BL 406 and BL# 408 concurrently across a specific voltage range, such as between 0.6V to 1.6V. Based on experimental testing, modulating BL 406 and BL# 408 between 0.6V to 1.6V allows the lock-in thermography to produce better phase and amplitude images of the bitcell thermal emission than other voltage ranges. However, other voltages may be better for different applications (e.g., different types of ICs having different circuitry designs). The examples disclosed herein provide a solution to obtain lock-in thermography images with high spatial resolution that is capable of detecting emission from a single bitcell. The relatively high resolution is achieved because a single bitcell is activated or modulated in isolation such that the resolution corresponds to the size of the bitcell. For current 6T SRAM bitcells, this size is around 200 nm, which is why the resolution of teachings disclosed herein are described as being around 200 nm. In some examples, the method can be expanded to other optical fault isolation applications in devices with backside power delivery architecture. In these other applications (e.g., for other ICs involving different circuitry) the size of the individual circuitry components being activated and/or modulated may differ from the 6T SRAM bitcell, such that the resulting resolution of the technique may also be different (e.g., larger or smaller than 200 nm). Backside power delivery architectures are devices that include power-delivering interconnects beneath the silicon.

Examples disclosed herein can precisely generate known reference emissions at the active transistor layers. In the case of lock-in thermography (LIT), these known thermal emissions can be used to gain important understanding of the relative z-locations of defects in the metal stack. The phase shift measurements at the usual frequencies used for LIT such as frequency between 1 Hz to 500 Hz does not offer sufficient resolution to pinpoint the exact depth of emissions from the bitcell defects. However, using a known reference source of emissions, the phase shift can be used to obtain information regarding the relative location of such bitcell defects. This offers the possibility of quickly differentiating between emissions originating from defects in the front metal layers from defects originating from the back metal layers. Examples disclosed herein can lead to a significant reduction in the delayering time required during the physical failure analysis of defects. Delayering is an inspection process in semiconductor testing to determine the relative depth, precise location and relative size of defects. Delayering is performed by selectively removing layers from a semiconductor device to access underlying structures, such as transistors or interconnects, for failure analysis or other testing purposes.

Examples disclosed herein offer a highly flexible alternative to carry out logical-to-physical (L2P) validation during the early stages of semiconductor testing. The method offers flexibility on the locations in the arrays that can be addressed using a low yield analysis test mode. The procedure is also non-destructive as it does not require inducing failures in functional devices. Furthermore, examples disclosed herein can be implemented within regular first in first out (FIFO) flows with high throughput. The total data collection time for this technique ranges from a few minutes to a couple of hours, depending on the complexity of the set-up. There are no additional requirements in terms of die packaging or wafer preparation steps other than the conventional flows established for conventional optical fault isolation (OFI).

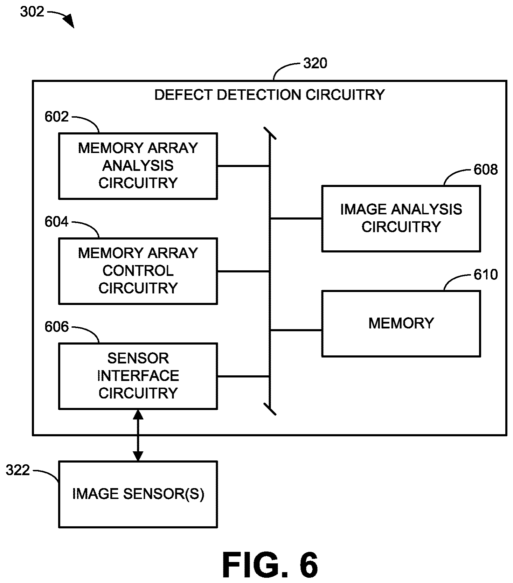

FIG. 6 is a block diagram of an example implementation of the defect detection circuitry 320 of the example defect detection apparatus 302 of FIG. 3 to improve inspection techniques to detect defects in integrated circuits (IC) with backside power delivery. The defect detection circuitry 320 of FIG. 6 may be instantiated (e.g., creating an instance of, bring into being for any length of time, materialize, implement, etc.) by programmable circuitry such as a Central Processor Unit (CPU) executing first instructions. Additionally or alternatively, the defect detection circuitry 320 of FIG. 6 may be instantiated (e.g., creating an instance of, bring into being for any length of time, materialize, implement, etc.) by (i) an Application Specific Integrated Circuit (ASIC) and/or (ii) a Field Programmable Gate Array (FPGA) structured and/or configured in response to execution of second instructions to perform operations corresponding to the first instructions. It should be understood that some or all of the circuitry of FIG. 6 may, thus, be instantiated at the same or different times. Some or all of the circuitry of FIG. 6 may be instantiated, for example, in one or more threads executing concurrently on hardware and/or in series on hardware. Moreover, in some examples, some or all of the circuitry of FIG. 6 may be implemented by microprocessor circuitry executing instructions and/or FPGA circuitry performing operations to implement one or more virtual machines and/or containers.

The example defect detection apparatus 302 includes example defect detection circuitry 320 and one or more imaging sensor 322. The example defect detection circuitry 320 includes example memory array analysis circuitry 602, example memory array control circuitry 604, example sensor interface circuitry 606, example image analysis circuitry 608, and example memory 610.

In some examples, the example memory array analysis circuitry 602 identifies whether there are any bitcell(s) (e.g., a 6T SRAM bitcell 312 of FIG. 3) to test in a memory array of an IC (e.g., the memory arrays 306, 308 of the DUT 304 of FIG. 3). In some examples, a bitcell to be tested is a bitcell that failed a high-speed AC raster test. Further testing that the defect detection circuitry 320 performs on the faulty bitcell is used for defect classification. In some examples, the memory array analysis circuitry 602 is instantiated by programmable circuitry executing memory array analysis instructions and/or configured to perform operations such as those represented by the flowchart(s) of FIGS. 7-9.

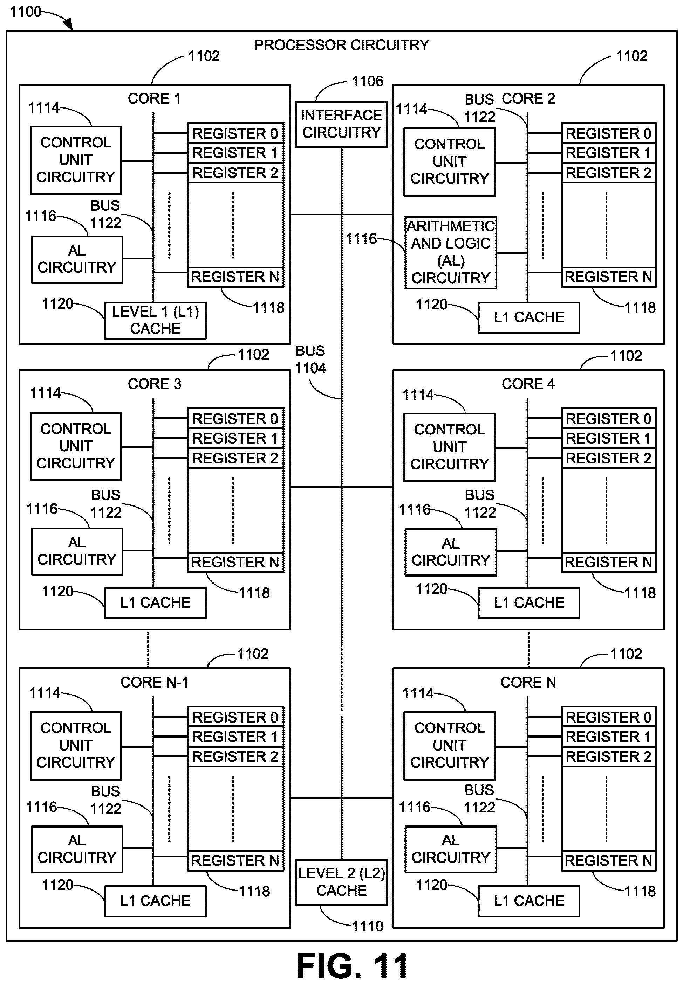

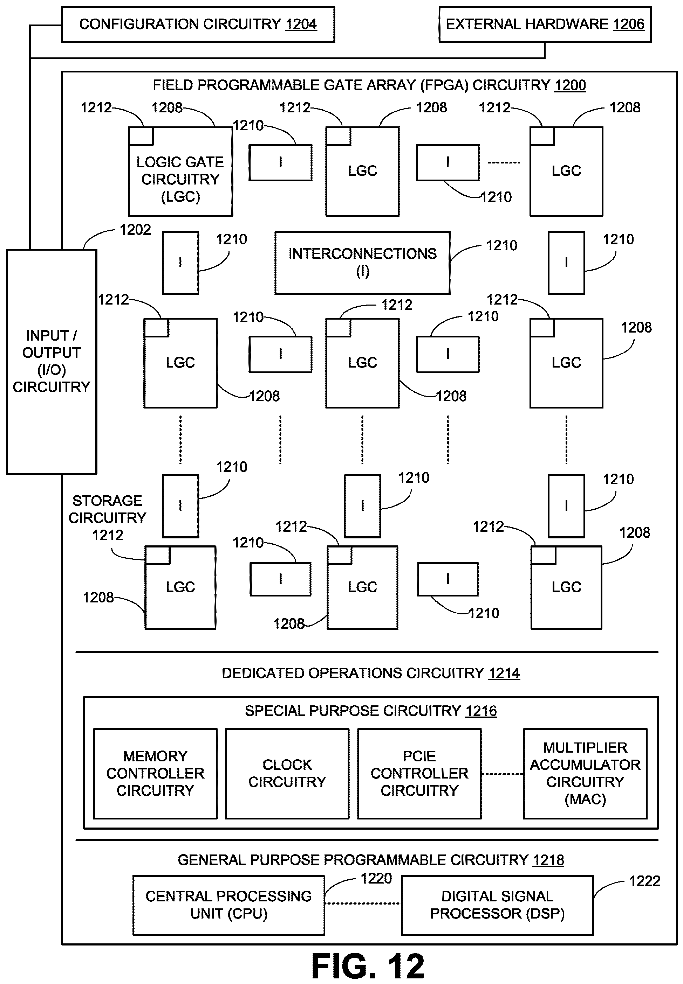

In some examples, the defect detection apparatus 302 includes means for identifying whether there are any bitcell to test in a memory array of an IC. For example, the means for identifying may be implemented by memory array analysis circuitry 602. In some examples, the memory array analysis circuitry 602 may be instantiated by programmable circuitry such as the example programmable circuitry 1012 of FIG. 10. For instance, the memory array analysis circuitry 602 may be instantiated by the example microprocessor 1100 of FIG. 11 executing machine executable instructions such as those implemented by at least blocks 702 of FIG. 7. In some examples, the memory array analysis circuitry 602 may be instantiated by hardware logic circuitry, which may be implemented by an ASIC, XPU, or the FPGA circuitry 1200 of FIG. 12 configured and/or structured to perform operations corresponding to the machine readable instructions. Additionally or alternatively, the memory array analysis circuitry 602 may be instantiated by any other combination of hardware, software, and/or firmware. For example, the memory array analysis circuitry 602 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the example memory array control circuitry 604 biases (e.g., controls) the 6T SRAM bitcell to an initial state and modulates first and second bitlines associated with the bitcell between a first voltage and a second voltage to generate a periodic heat signal. The voltage is modulated at a certain frequency for a period of time. In some examples, the frequency is between 1 Hz and 100 Hz. In some examples, the memory array control circuitry 604 is instantiated by programmable circuitry executing memory array control instructions and/or configured to perform operations such as those represented by the flowchart(s) of FIGS. 7 - 9.

In some examples, the memory array control circuitry 604 biases the bitcell to an initial state by turning 'on' the associated wordline to first and second pass gates transistors of the bitcell. The memory array control circuitry 604 controls the first bitline of bitcell to Vss (e.g., Vss = 0V). The memory array control circuitry 604 controls the second bitline of bitcell to a first voltage above 0V (e.g., Vcc = 0.6V). In some examples, the first voltage is approximately 0.6V and the second voltage is approximately 1.6V.

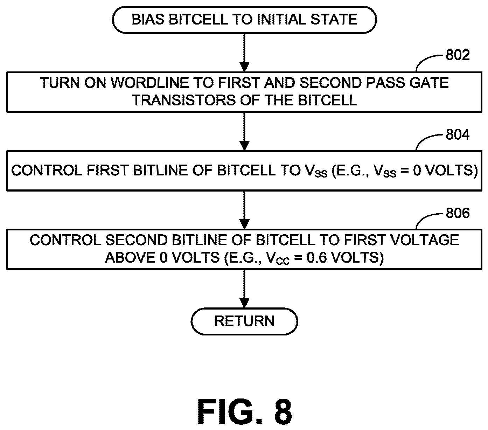

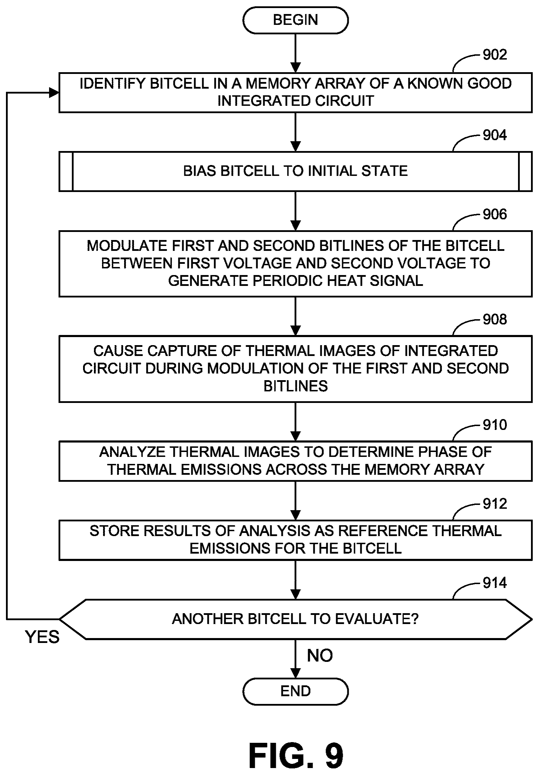

In some examples, the defect detection apparatus 302 includes means for biasing a bitcell to an initial state and modulating first and second bitlines. For example, the means for biasing and modulating may be implemented by memory array control circuitry 604. In some examples, the memory array control circuitry 604 may be instantiated by programmable circuitry such as the example programmable circuitry 1012 of FIG. 10. For instance, the memory array control circuitry 604 may be instantiated by the example microprocessor 1100 of FIG. 11 executing machine executable instructions such as those implemented by at least blocks 704, 706 of FIG. 7, 802, 804, 806 of FIG. 8 and 904, 906 of FIG. 9. In some examples, the memory array control circuitry 604 may be instantiated by hardware logic circuitry, which may be implemented by an ASIC, XPU, or the FPGA circuitry 1200 of FIG. 12 configured and/or structured to perform operations corresponding to the machine readable instructions. Additionally or alternatively, the memory array control circuitry 604 may be instantiated by any other combination of hardware, software, and/or firmware. For example, the memory array control circuitry 604 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the example sensor interface circuitry 606 causes the imaging sensor(s) 322 to capture images (e.g., thermal images) of the IC during modulation of the first and second bitlines. In some examples, the imaging sensor 322 is an infrared camera, thermal infrared detectors, thermocouples, photodetectors or any other thermal detectors. In some examples, the sensor interface circuitry 606 is instantiated by programmable circuitry executing sensor interface instructions and/or configured to perform operations such as those represented by the flowchart(s) of FIGS. 7-9.

In some examples, the defect detection apparatus 302 includes means for causing a thermal imaging sensor to capture a series of images of the IC. For example, the means for causing a thermal imaging sensor to capture a series of images may be implemented by sensor interface circuitry 606. In some examples, the sensor interface circuitry 606 may be instantiated by programmable circuitry such as the example programmable circuitry 1012 of FIG. 10. For instance, the sensor interface circuitry 606 may be instantiated by the example microprocessor 1100 of FIG. 11 executing machine executable instructions such as those implemented by at least blocks 708 of FIG. 7 and 908 of FIG. 9. In some examples, the sensor interface circuitry 606 may be instantiated by hardware logic circuitry, which may be implemented by an ASIC, XPU, or the FPGA circuitry 1200 of FIG. 12 configured and/or structured to perform operations corresponding to the machine readable instructions. Additionally or alternatively, the sensor interface circuitry 606 may be instantiated by any other combination of hardware, software, and/or firmware. For example, the sensor interface circuitry 606 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the example image analysis circuitry 608 determines the location of bitcell(s) within the memory array based on an amplitude of thermal emissions from the IC captured in the thermal images. The example image analysis circuitry 608 analyzes the thermal images to determine a phase of the thermal emissions across the memory array. The example image analysis circuitry 608 determines a location of a defect based on a region of memory array where the thermal emissions are out of phase with the periodic heat signal. The example image analysis circuitry 608 estimates a z-height of the defect based on a comparison of a phase shift of the thermal emissions relative to a reference thermal emission. In some examples, the reference thermal emissions are based on emissions from a corresponding bitcell in a known good IC. In some examples, the image analysis circuitry 608 determines location of the defect within a precision of 200 nm (e.g., 0.2 µm). In some examples, the defect is less than 0.2 µm. In some examples, the image analysis circuitry 608 is instantiated by programmable circuitry executing image analysis instructions and/or configured to perform operations such as those represented by the flowchart(s) of FIGS. 7-9.

In some examples, the defect detection apparatus 302 includes means for determining a location of a defect in the IC. For example, the means for determining may be implemented by image analysis circuitry 608. In some examples, the image analysis circuitry 608 may be instantiated by programmable circuitry such as the example programmable circuitry 1012 of FIG. 10. For instance, the image analysis circuitry 608 may be instantiated by the example microprocessor 1100 of FIG. 11 executing machine executable instructions such as those implemented by at least blocks 710, 712, 714, 716, 718 of FIG. 7 and 910 of FIG. 9. In some examples, the image analysis circuitry 608 may be instantiated by hardware logic circuitry, which may be implemented by an ASIC, XPU, or the FPGA circuitry 1200 of FIG. 12 configured and/or structured to perform operations corresponding to the machine readable instructions. Additionally or alternatively, the image analysis circuitry 608 may be instantiated by any other combination of hardware, software, and/or firmware. For example, the image analysis circuitry 608 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

In some examples, the example memory 610 store results of the thermal images analysis (e.g., the precise location of a detected defect). Additionally or alternatively, the example memory 610 stores thermal emissions data for non-defective (known good) ICs as a reference thermal emission for individual bitcell(s) in the IC.

While an example manner of implementing the defect detection circuitry 320 of FIG. 3 is illustrated in FIG. 6, one or more of the elements, processes, and/or devices illustrated in FIG. 6 may be combined, divided, re-arranged, omitted, eliminated, and/or implemented in any other way. Further, the example memory array analysis circuitry 602, the example memory array control circuitry 604, the example sensor interface circuitry 606, the example image analysis circuitry 608, the example memory 610, and/or, more generally, the example defect detection circuitry 320 of FIG. 6, may be implemented by hardware alone or by hardware in combination with software and/or firmware. Thus, for example, any of the example memory array analysis circuitry 602, the example memory array control circuitry 604, the example sensor interface circuitry 606, the example image analysis circuitry 608, the example memory 610, and/or, more generally, the example defect detection circuitry 320, could be implemented by programmable circuitry in combination with machine readable instructions (e.g., firmware or software), processor circuitry, analog circuit(s), digital circuit(s), logic circuit(s), programmable processor(s), programmable microcontroller(s), graphics processing unit(s) (GPU(s)), digital signal processor(s) (DSP(s)), ASIC(s), programmable logic device(s) (PLD(s)), and/or field programmable logic device(s) (FPLD(s)) such as FPGAs. Further still, the example defect detection circuitry 320 of FIG. 6 may include one or more elements, processes, and/or devices in addition to, or instead of, those illustrated in FIG. 6, and/or may include more than one of any or all of the illustrated elements, processes and devices.

Flowchart(s) representative of example machine readable instructions, which may be executed by programmable circuitry to implement and/or instantiate the defect detection circuitry 320 of FIG. 6 and/or representative of example operations which may be performed by programmable circuitry to implement and/or instantiate the defect detection circuitry 320 of FIG. 6, are shown in FIGS. 7-9. The machine readable instructions may be one or more executable programs or portion(s) of one or more executable programs for execution by programmable circuitry such as the programmable circuitry 1012 shown in the example processor platform 1000 discussed below in connection with FIG. 10 and/or may be one or more function(s) or portion(s) of functions to be performed by the example programmable circuitry (e.g., an FPGA) discussed below in connection with FIGS. 11 and/or 12. In some examples, the machine readable instructions cause an operation, a task, etc., to be carried out and/or performed in an automated manner in the real world. As used herein, "automated" means without human involvement.

The program may be embodied in instructions (e.g., software and/or firmware) stored on one or more non-transitory computer readable and/or machine readable storage medium such as cache memory, a magnetic-storage device or disk (e.g., a floppy disk, a Hard Disk Drive (HDD), etc.), an optical-storage device or disk (e.g., a Blu-ray disk, a Compact Disk (CD), a Digital Versatile Disk (DVD), etc.), a Redundant Array of Independent Disks (RAID), a register, ROM, a solid-state drive (SSD), SSD memory, non-volatile memory (e.g., electrically erasable programmable read-only memory (EEPROM), flash memory, etc.), volatile memory (e.g., Random Access Memory (RAM) of any type, etc.), and/or any other storage device or storage disk. The instructions of the non-transitory computer readable and/or machine readable medium may program and/or be executed by programmable circuitry located in one or more hardware devices, but the entire program and/or parts thereof could alternatively be executed and/or instantiated by one or more hardware devices other than the programmable circuitry and/or embodied in dedicated hardware. The machine readable instructions may be distributed across multiple hardware devices and/or executed by two or more hardware devices (e.g., a server and a client hardware device). For example, the client hardware device may be implemented by an endpoint client hardware device (e.g., a hardware device associated with a human and/or machine user) or an intermediate client hardware device gateway (e.g., a radio access network (RAN)) that may facilitate communication between a server and an endpoint client hardware device. Similarly, the non-transitory computer readable storage medium may include one or more mediums. Further, although the example program is described with reference to the flowchart(s) illustrated in FIGS. 7-9, many other methods of implementing the example defect detection apparatus 302 may alternatively be used. For example, the order of execution of the blocks of the flowchart(s) may be changed, and/or some of the blocks described may be changed, eliminated, or combined. Additionally or alternatively, any or all of the blocks of the flow chart may be implemented by one or more hardware circuits (e.g., processor circuitry, discrete and/or integrated analog and/or digital circuitry, an FPGA, an ASIC, a comparator, an operational-amplifier (op-amp), a logic circuit, etc.) structured to perform the corresponding operation without executing software or firmware. The programmable circuitry may be distributed in different network locations and/or local to one or more hardware devices (e.g., a single-core processor (e.g., a single core CPU), a multi-core processor (e.g., a multi-core CPU, an XPU, etc.)). For example, the programmable circuitry may be a CPU and/or an FPGA located in the same package (e.g., the same integrated circuit (IC) package or in two or more separate housings), one or more processors in a single machine, multiple processors distributed across multiple servers of a server rack, multiple processors distributed across one or more server racks, etc., and/or any combination(s) thereof.

The machine readable instructions described herein may be stored in one or more of a compressed format, an encrypted format, a fragmented format, a compiled format, an executable format, a packaged format, etc. Machine readable instructions as described herein may be stored as data (e.g., computer-readable data, machine-readable data, one or more bits (e.g., one or more computer-readable bits, one or more machine-readable bits, etc.), a bitstream (e.g., a computer-readable bitstream, a machine-readable bitstream, etc.), etc.) or a data structure (e.g., as portion(s) of instructions, code, representations of code, etc.) that may be utilized to create, manufacture, and/or produce machine executable instructions. For example, the machine readable instructions may be fragmented and stored on one or more storage devices, disks and/or computing devices (e.g., servers) located at the same or different locations of a network or collection of networks (e.g., in the cloud, in edge devices, etc.). The machine readable instructions may require one or more of installation, modification, adaptation, updating, combining, supplementing, configuring, decryption, decompression, unpacking, distribution, reassignment, compilation, etc., in order to make them directly readable, interpretable, and/or executable by a computing device and/or other machine. For example, the machine readable instructions may be stored in multiple parts, which are individually compressed, encrypted, and/or stored on separate computing devices, wherein the parts when decrypted, decompressed, and/or combined form a set of computer-executable and/or machine executable instructions that implement one or more functions and/or operations that may together form a program such as that described herein.

In another example, the machine readable instructions may be stored in a state in which they may be read by programmable circuitry, but require addition of a library (e.g., a dynamic link library (DLL)), a software development kit (SDK), an application programming interface (API), etc., in order to execute the machine-readable instructions on a particular computing device or other device. In another example, the machine readable instructions may need to be configured (e.g., settings stored, data input, network addresses recorded, etc.) before the machine readable instructions and/or the corresponding program(s) can be executed in whole or in part. Thus, machine readable, computer readable and/or machine readable media, as used herein, may include instructions and/or program(s) regardless of the particular format or state of the machine readable instructions and/or program(s).

The machine readable instructions described herein can be represented by any past, present, or future instruction language, scripting language, programming language, etc. For example, the machine readable instructions may be represented using any of the following languages: C, C++, Java, C#, Perl, Python, JavaScript, HyperText Markup Language (HTML), Structured Query Language (SQL), Swift, etc.

As mentioned above, the example operations of FIGS. 7-9 may be implemented using executable instructions (e.g., computer readable and/or machine readable instructions) stored on one or more non-transitory computer readable and/or machine readable media. As used herein, the terms non-transitory computer readable medium, non-transitory computer readable storage medium, non-transitory machine readable medium, and/or non-transitory machine readable storage medium are expressly defined to include any type of computer readable storage device and/or storage disk and to exclude propagating signals and to exclude transmission media. Examples of such non-transitory computer readable medium, non-transitory computer readable storage medium, non-transitory machine readable medium, and/or non-transitory machine readable storage medium include optical storage devices, magnetic storage devices, an HDD, a flash memory, a read-only memory (ROM), a CD, a DVD, a cache, a RAM of any type, a register, and/or any other storage device or storage disk in which information is stored for any duration (e.g., for extended time periods, permanently, for brief instances, for temporarily buffering, and/or for caching of the information). As used herein, the terms "non-transitory computer readable storage device" and "non-transitory machine readable storage device" are defined to include any physical (mechanical, magnetic and/or electrical) hardware to retain information for a time period, but to exclude propagating signals and to exclude transmission media. Examples of non-transitory computer readable storage devices and/ or non-transitory machine readable storage devices include random access memory of any type, read only memory of any type, solid state memory, flash memory, optical discs, magnetic disks, disk drives, and/or redundant array of independent disks (RAID) systems. As used herein, the term "device" refers to physical structure such as mechanical and/or electrical equipment, hardware, and/or circuitry that may or may not be configured by computer readable instructions, machine readable instructions, etc., and/or manufactured to execute computer-readable instructions, machine-readable instructions, etc.

FIG. 7 is a flowchart representative of example machine readable instructions and/or example operations 700 that may be executed, instantiated, and/or performed by programmable circuitry to implement the defect detection circuitry 320 of FIG. 6 to detect defects in an IC. The example machine-readable instructions and/or the example operations 700 of FIG. 7 begin at block 702, at which the memory array analysis circuitry 602 (FIG. 6) identifies a bitcell in a memory array of an IC to test. The example memory array control circuitry 604 (FIG. 6) biases the bitcell to an initial state (block 704). Further details of biasing the bitcell are discussed in connection with FIG. 8. The memory array control circuitry 604 modulates first and second bitlines of the bitcell between a first voltage and a second voltage to generate a periodic heat signal (block 706). The sensor interface circuitry 606 (FIG. 6) causes a thermal imaging sensor 322 (FIG. 6) to capture thermal images of the IC during modulation of the first and second bitlines (block 708). The example image analysis circuitry 608 (FIG. 6) determines a location of the bitcell within the memory array based on an amplitude of thermal emissions from the IC captured in the thermal images (block 710). The example image analysis circuitry 608 analyzes thermal images to determine a phase of the thermal emissions across the memory array (block 712). The example image analysis circuitry 608 determines the location of a defect based on a region of the memory array where the thermal emissions are out of phase with the periodic heat signal (block 714). The example image analysis circuitry 608 estimates a z-height of the defect based on a comparison of a phase shift of the thermal emissions relative to a reference thermal emission (block 716). The memory array analysis circuitry 604 determines if there is another bitcell to test (block 718). If there is another bitcell to test (block 718: YES), control returns to block 702. If there is no other bitcell to test (block 718: NO), the example instructions and/or operations of FIG. 7 end.

FIG. 8 is a flowchart representative of example machine readable instructions and/or example operations 800 that may be executed, instantiated, and/or performed by programmable circuitry to implement the memory array control circuitry 604 of FIG. 6 to bias the bitcell to an initial state. The example machine-readable instructions and/or the example operations 800 of FIG. 8 begin at block 802, at which the memory array control circuitry 604 turns on wordline 422 (FIG. 4) to first and second pass gate transistors 402, 404 (FIG. 4) of the bitcell 312 (FIG. 4). At block 804, the memory array control circuitry 604 controls a first bitline BL 406 (FIG. 4) of the bitcell 312 (FIG. 4) to Vss 410 (FIG. 4), where Vss = 0V. At block 806, the memory array control circuitry 604 controls a second bitline BL# 408 (FIG. 4) of the bitcell 312 to Vcc 412 (FIG. 4), where Vcc = 0.6V. The example instructions and/or operations of FIG. 8 returns to block 706 of FIG. 7 or block 906 of FIG. 9.

FIG. 9 is a flowchart representative of example machine readable instructions and/or example operations 900 that may be executed, instantiated, and/or performed by programmable circuitry to implement the defect detection circuitry 320 of FIG. 6 to identify a known good bitcell and store a reference thermal emission for the bitcell. The example machine-readable instructions and/or the example operations 900 of FIG. 9 begin at block 902, at which the memory array analysis circuitry 602 (FIG. 6) identifies a bitcell in a memory array of a known good IC. The memory array control circuitry 604 (FIG. 6) biases the bitcell to an initial state (block 904). An example implementation of block 904 is provided above in connection with FIG. 8. The memory array control circuitry 604 modulates first and second bitlines of the bitcell between a first voltage and a second voltage to generate periodic heat signal (block 906). The sensor interface circuitry 606 (FIG. 6) causes a thermal imaging sensor 322 (FIG. 6) to capture thermal images of IC during modulation of the first and second bitlines (block 908). The image analysis circuitry 608 (FIG. 6) analyzes thermal images to determine a phase of thermal emissions across the memory array (block 910). The memory 610 (FIG. 6) stores results of the analysis as reference thermal emissions for the bitcell (block 912). The memory array analysis circuitry 602 determines whether there is another bitcell to evaluate (block 914). If there is another bitcell to evaluate (block 914: YES), control returns to block 902. If there is no other bitcell to evaluate (block 914: NO), the example instructions and/or operations of FIG. 9 end.

FIG. 10 is a block diagram of an example programmable circuitry platform 1000 structured to execute and/or instantiate the example machine-readable instructions and/or the example operations of FIGS. 7-9 to implement the defect detection circuitry 320 of FIG. 6. The programmable circuitry platform 1000 can be, for example, a server, a personal computer, a workstation, a self-learning machine (e.g., a neural network), a mobile device (e.g., a cell phone, a smart phone, a tablet such as an iPad^{™}), a personal digital assistant (PDA), an Internet appliance, a headset (e.g., an augmented reality (AR) headset, a virtual reality (VR) headset, etc.) or other wearable device, or any other type of computing and/or electronic device.

The programmable circuitry platform 1000 of the illustrated example includes programmable circuitry 1012. The programmable circuitry 1012 of the illustrated example is hardware. For example, the programmable circuitry 1012 can be implemented by one or more integrated circuits, logic circuits, FPGAs, microprocessors, CPUs, GPUs, DSPs, and/or microcontrollers from any desired family or manufacturer. The programmable circuitry 1012 may be implemented by one or more semiconductor based (e.g., silicon based) devices. In this example, the programmable circuitry 1012 implements the example memory array analysis circuitry 602, the example memory array control circuitry 604, the example sensor interface circuitry 606, the example image analysis circuitry 608, the example memory 610, and/or, more generally, the example defect detection circuitry 320.

The programmable circuitry 1012 of the illustrated example includes a local memory 1013 (e.g., a cache, registers, etc.). The programmable circuitry 1012 of the illustrated example is in communication with main memory 1014, 1016, which includes a volatile memory 1014 and a non-volatile memory 1016, by a bus 1018. The volatile memory 1014 may be implemented by Synchronous Dynamic Random Access Memory (SDRAM), Dynamic Random Access Memory (DRAM), RAMBUS^{®} Dynamic Random Access Memory (RDRAM^{®}), and/or any other type of RAM device. The non-volatile memory 1016 may be implemented by flash memory and/or any other desired type of memory device. Access to the main memory 1014, 1016 of the illustrated example is controlled by a memory controller 1017. In some examples, the memory controller 1017 may be implemented by one or more integrated circuits, logic circuits, microcontrollers from any desired family or manufacturer, or any other type of circuitry to manage the flow of data going to and from the main memory 1014, 1016.

The programmable circuitry platform 1000 of the illustrated example also includes interface circuitry 1020. The interface circuitry 1020 may be implemented by hardware in accordance with any type of interface standard, such as an Ethernet interface, a universal serial bus (USB) interface, a Bluetooth^{®} interface, a near field communication (NFC) interface, a Peripheral Component Interconnect (PCI) interface, and/or a Peripheral Component Interconnect Express (PCIe) interface.

In the illustrated example, one or more input devices 1022 are connected to the interface circuitry 1020. The input device(s) 1022 permit(s) a user (e.g., a human user, a machine user, etc.) to enter data and/or commands into the programmable circuitry 1012. The input device(s) 1022 can be implemented by, for example, an audio sensor, a microphone, a camera (still or video), a keyboard, a button, a mouse, a touchscreen, a trackpad, a trackball, an isopoint device, and/or a voice recognition system.

One or more output devices 1024 are also connected to the interface circuitry 1020 of the illustrated example. The output device(s) 1024 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.), a tactile output device, a printer, and/or speaker. The interface circuitry 1020 of the illustrated example, thus, typically includes a graphics driver card, a graphics driver chip, and/or graphics processor circuitry such as a GPU.

The interface circuitry 1020 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 1026. The communication can be by, for example, an Ethernet connection, a digital subscriber line (DSL) connection, a telephone line connection, a coaxial cable system, a satellite system, a beyond-line-of-sight wireless system, a line-of-sight wireless system, a cellular telephone system, an optical connection, etc.

The programmable circuitry platform 1000 of the illustrated example also includes one or more mass storage discs or devices 1028 to store firmware, software, and/or data. Examples of such mass storage discs or devices 1028 include magnetic storage devices (e.g., floppy disk, drives, HDDs, etc.), optical storage devices (e.g., Blu-ray disks, CDs, DVDs, etc.), RAID systems, and/or solid-state storage discs or devices such as flash memory devices and/or SSDs. In some examples, the mass storage devices 1028 implements the memory 610 of FIG. 6.

The machine readable instructions 1032, which may be implemented by the machine readable instructions of FIGS. 7-9, may be stored in the mass storage device 1028, in the volatile memory 1014, in the non-volatile memory 1016, and/or on at least one non-transitory computer readable storage medium such as a CD or DVD which may be removable.

FIG. 11 is a block diagram of an example implementation of the programmable circuitry 1012 of FIG. 10. In this example, the programmable circuitry 1012 of FIG. 10 is implemented by a microprocessor 1100. For example, the microprocessor 1100 may be a general-purpose microprocessor (e.g., general-purpose microprocessor circuitry). The microprocessor 1100 executes some or all of the machine-readable instructions of the flowcharts of FIGS. 7-9 to effectively instantiate the circuitry of FIG. 2 as logic circuits to perform operations corresponding to those machine readable instructions. In some such examples, the circuitry of FIG. 6 is instantiated by the hardware circuits of the microprocessor 1100 in combination with the machine-readable instructions. For example, the microprocessor 1100 may be implemented by multi-core hardware circuitry such as a CPU, a DSP, a GPU, an XPU, etc. Although it may include any number of example cores 1102 (e.g., 1 core), the microprocessor 1100 of this example is a multi-core semiconductor device including N cores. The cores 1102 of the microprocessor 1100 may operate independently or may cooperate to execute machine readable instructions. For example, machine code corresponding to a firmware program, an embedded software program, or a software program may be executed by one of the cores 1102 or may be executed by multiple ones of the cores 1102 at the same or different times. In some examples, the machine code corresponding to the firmware program, the embedded software program, or the software program is split into threads and executed in parallel by two or more of the cores 1102. The software program may correspond to a portion or all of the machine readable instructions and/or operations represented by the flowcharts of FIGS. 7-9.

The cores 1102 may communicate by a first example bus 1104. In some examples, the first bus 1104 may be implemented by a communication bus to effectuate communication associated with one(s) of the cores 1102. For example, the first bus 1104 may be implemented by at least one of an Inter-Integrated Circuit (I2C) bus, a Serial Peripheral Interface (SPI) bus, a PCI bus, or a PCIe bus. Additionally or alternatively, the first bus 1104 may be implemented by any other type of computing or electrical bus. The cores 1102 may obtain data, instructions, and/or signals from one or more external devices by example interface circuitry 1106. The cores 1102 may output data, instructions, and/or signals to the one or more external devices by the interface circuitry 1106. Although the cores 1102 of this example include example local memory 1120 (e.g., Level 1 (L1) cache that may be split into an L1 data cache and an L1 instruction cache), the microprocessor 1100 also includes example shared memory 1110 that may be shared by the cores (e.g., Level 2 (L2 cache)) for high-speed access to data and/or instructions. Data and/or instructions may be transferred (e.g., shared) by writing to and/or reading from the shared memory 1110. The local memory 1120 of each of the cores 1102 and the shared memory 1110 may be part of a hierarchy of storage devices including multiple levels of cache memory and the main memory (e.g., the main memory 1014, 1016 of FIG. 10). Typically, higher levels of memory in the hierarchy exhibit lower access time and have smaller storage capacity than lower levels of memory. Changes in the various levels of the cache hierarchy are managed (e.g., coordinated) by a cache coherency policy.

Each core 1102 may be referred to as a CPU, DSP, GPU, etc., or any other type of hardware circuitry. Each core 1102 includes control unit circuitry 1114, arithmetic and logic (AL) circuitry (sometimes referred to as an ALU) 1116, a plurality of registers 1118, the local memory 1120, and a second example bus 1122. Other structures may be present. For example, each core 1102 may include vector unit circuitry, single instruction multiple data (SIMD) unit circuitry, load/store unit (LSU) circuitry, branch/jump unit circuitry, floating-point unit (FPU) circuitry, etc. The control unit circuitry 1114 includes semiconductor-based circuits structured to control (e.g., coordinate) data movement within the corresponding core 1102. The AL circuitry 1116 includes semiconductor-based circuits structured to perform one or more mathematic and/or logic operations on the data within the corresponding core 1102. The AL circuitry 1116 of some examples performs integer based operations. In other examples, the AL circuitry 1116 also performs floating-point operations. In yet other examples, the AL circuitry 1116 may include first AL circuitry that performs integer-based operations and second AL circuitry that performs floating-point operations. In some examples, the AL circuitry 1116 may be referred to as an Arithmetic Logic Unit (ALU).

The registers 1118 are semiconductor-based structures to store data and/or instructions such as results of one or more of the operations performed by the AL circuitry 1116 of the corresponding core 1102. For example, the registers 1118 may include vector register(s), SIMD register(s), general-purpose register(s), flag register(s), segment register(s), machine-specific register(s), instruction pointer register(s), control register(s), debug register(s), memory management register(s), machine check register(s), etc. The registers 1118 may be arranged in a bank as shown in FIG. 11. Alternatively, the registers 1118 may be organized in any other arrangement, format, or structure, such as by being distributed throughout the core 1102 to shorten access time. The second bus 1122 may be implemented by at least one of an I2C bus, a SPI bus, a PCI bus, or a PCIe bus.

Each core 1102 and/or, more generally, the microprocessor 1100 may include additional and/or alternate structures to those shown and described above. For example, one or more clock circuits, one or more power supplies, one or more power gates, one or more cache home agents (CHAs), one or more converged/common mesh stops (CMSs), one or more shifters (e.g., barrel shifter(s)) and/or other circuitry may be present. The microprocessor 1100 is a semiconductor device fabricated to include many transistors interconnected to implement the structures described above in one or more integrated circuits (ICs) contained in one or more packages.

The microprocessor 1100 may include and/or cooperate with one or more accelerators (e.g., acceleration circuitry, hardware accelerators, etc.). In some examples, accelerators are implemented by logic circuitry to perform certain tasks more quickly and/or efficiently than can be done by a general-purpose processor. Examples of accelerators include ASICs and FPGAs such as those discussed herein. A GPU, DSP and/or other programmable device can also be an accelerator. Accelerators may be on-board the microprocessor 1100, in the same chip package as the microprocessor 1100 and/or in one or more separate packages from the microprocessor 1100.

FIG. 12 is a block diagram of another example implementation of the programmable circuitry 1012 of FIG. 10. In this example, the programmable circuitry 1012 is implemented by FPGA circuitry 1200. For example, the FPGA circuitry 1200 may be implemented by an FPGA. The FPGA circuitry 1200 can be used, for example, to perform operations that could otherwise be performed by the example microprocessor 1100 of FIG. 11 executing corresponding machine readable instructions. However, once configured, the FPGA circuitry 1200 instantiates the operations and/or functions corresponding to the machine readable instructions in hardware and, thus, can often execute the operations/functions faster than they could be performed by a general-purpose microprocessor executing the corresponding software.

More specifically, in contrast to the microprocessor 1100 of FIG. 11 described above (which is a general purpose device that may be programmed to execute some or all of the machine readable instructions represented by the flowchart(s) of FIGS. 7-9 but whose interconnections and logic circuitry are fixed once fabricated), the FPGA circuitry 1200 of the example of FIG. 12 includes interconnections and logic circuitry that may be configured, structured, programmed, and/or interconnected in different ways after fabrication to instantiate, for example, some or all of the operations/functions corresponding to the machine readable instructions represented by the flowchart(s) of FIGS. 7-9. In particular, the FPGA circuitry 1200 may be thought of as an array of logic gates, interconnections, and switches. The switches can be programmed to change how the logic gates are interconnected by the interconnections, effectively forming one or more dedicated logic circuits (unless and until the FPGA circuitry 1200 is reprogrammed). The configured logic circuits enable the logic gates to cooperate in different ways to perform different operations on data received by input circuitry. Those operations may correspond to some or all of the instructions (e.g., the software and/or firmware) represented by the flowchart(s) of FIGS. 7-9. As such, the FPGA circuitry 1200 may be configured and/or structured to effectively instantiate some or all of the operations/functions corresponding to the machine readable instructions of the flowchart(s) of FIGS. 7-9 as dedicated logic circuits to perform the operations/functions corresponding to those software instructions in a dedicated manner analogous to an ASIC. Therefore, the FPGA circuitry 1200 may perform the operations/functions corresponding to the some or all of the machine readable instructions of FIGS. 7-9 faster than the general-purpose microprocessor can execute the same.

In the example of FIG. 12, the FPGA circuitry 1200 is configured and/or structured in response to being programmed (and/or reprogrammed one or more times) based on a binary file. In some examples, the binary file may be compiled and/or generated based on instructions in a hardware description language (HDL) such as Lucid, Very High Speed Integrated Circuits (VHSIC) Hardware Description Language (VHDL), or Verilog. For example, a user (e.g., a human user, a machine user, etc.) may write code or a program corresponding to one or more operations/functions in an HDL; the code/program may be translated into a low-level language as needed; and the code/program (e.g., the code/program in the low-level language) may be converted (e.g., by a compiler, a software application, etc.) into the binary file. In some examples, the FPGA circuitry 1200 of FIG. 12 may access and/or load the binary file to cause the FPGA circuitry 1200 of FIG. 12 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 1200 of FIG. 12 to cause configuration and/or structuring of the FPGA circuitry 1200 of FIG. 12, or portion(s) thereof.

In some examples, the binary file is compiled, generated, transformed, and/or otherwise output from a uniform software platform utilized to program FPGAs. For example, the uniform software platform may translate first instructions (e.g., code or a program) that correspond to one or more operations/functions in a high-level language (e.g., C, C++, Python, etc.) into second instructions that correspond to the one or more operations/functions in an HDL. In some such examples, the binary file is compiled, generated, and/or otherwise output from the uniform software platform based on the second instructions. In some examples, the FPGA circuitry 1200 of FIG. 12 may access and/or load the binary file to cause the FPGA circuitry 1200 of FIG. 12 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 1200 of FIG. 12 to cause configuration and/or structuring of the FPGA circuitry 1200 of FIG. 12, or portion(s) thereof.

The FPGA circuitry 1200 of FIG. 12, includes example input/output (I/O) circuitry 1202 to obtain and/or output data to/from example configuration circuitry 1204 and/or external hardware 1206. For example, the configuration circuitry 1204 may be implemented by interface circuitry that may obtain a binary file, which may be implemented by a bit stream, data, and/or machine-readable instructions, to configure the FPGA circuitry 1200, or portion(s) thereof. In some such examples, the configuration circuitry 1204 may obtain the binary file from a user, a machine (e.g., hardware circuitry (e.g., programmable or dedicated circuitry) that may implement an Artificial Intelligence/Machine Learning (AI/ML) model to generate the binary file), etc., and/or any combination(s) thereof). In some examples, the external hardware 1206 may be implemented by external hardware circuitry. For example, the external hardware 1206 may be implemented by the microprocessor 1100 of FIG. 11.

The FPGA circuitry 1200 also includes an array of example logic gate circuitry 1208, a plurality of example configurable interconnections 1210, and example storage circuitry 1212. The logic gate circuitry 1208 and the configurable interconnections 1210 are configurable to instantiate one or more operations/functions that may correspond to at least some of the machine readable instructions of FIGS. 7-9 and/or other desired operations. The logic gate circuitry 1208 shown in FIG. 12 is fabricated in blocks or groups. Each block includes semiconductor-based electrical structures that may be configured into logic circuits. In some examples, the electrical structures include logic gates (e.g., And gates, Or gates, Nor gates, etc.) that provide basic building blocks for logic circuits. Electrically controllable switches (e.g., transistors) are present within each of the logic gate circuitry 1208 to enable configuration of the electrical structures and/or the logic gates to form circuits to perform desired operations/functions. The logic gate circuitry 1208 may include other electrical structures such as look-up tables (LUTs), registers (e.g., flip-flops or latches), multiplexers, etc.

The configurable interconnections 1210 of the illustrated example are conductive pathways, traces, vias, or the like that may include electrically controllable switches (e.g., transistors) whose state can be changed by programming (e.g., using an HDL instruction language) to activate or deactivate one or more connections between one or more of the logic gate circuitry 1208 to program desired logic circuits.

The storage circuitry 1212 of the illustrated example is structured to store result(s) of the one or more of the operations performed by corresponding logic gates. The storage circuitry 1212 may be implemented by registers or the like. In the illustrated example, the storage circuitry 1212 is distributed amongst the logic gate circuitry 1208 to facilitate access and increase execution speed.

The example FPGA circuitry 1200 of FIG. 12 also includes example dedicated operations circuitry 1214. In this example, the dedicated operations circuitry 1214 includes special purpose circuitry 1216 that may be invoked to implement commonly used functions to avoid the need to program those functions in the field. Examples of such special purpose circuitry 1216 include memory (e.g., DRAM) controller circuitry, PCIe controller circuitry, clock circuitry, transceiver circuitry, memory, and multiplier-accumulator circuitry. Other types of special purpose circuitry may be present. In some examples, the FPGA circuitry 1200 may also include example general purpose programmable circuitry 1218 such as an example CPU 1220 and/or an example DSP 1222. Other general purpose programmable circuitry 1218 may additionally or alternatively be present such as a GPU, an XPU, etc., that can be programmed to perform other operations.

Although FIGS. 11 and 12 illustrate two example implementations of the programmable circuitry 1012 of FIG. 10, many other approaches are contemplated. For example, FPGA circuitry may include an on-board CPU, such as one or more of the example CPU 1220 of FIG. 11. Therefore, the programmable circuitry 1012 of FIG. 10 may additionally be implemented by combining at least the example microprocessor 1100 of FIG. 11 and the example FPGA circuitry 1200 of FIG. 12. In some such hybrid examples, one or more cores 1102 of FIG. 11 may execute a first portion of the machine readable instructions represented by the flowchart(s) of FIGS. 7-9 to perform first operation(s)/function(s), the FPGA circuitry 1200 of FIG. 12 may be configured and/or structured to perform second operation(s)/function(s) corresponding to a second portion of the machine readable instructions represented by the flowcharts of FIG. 7-9, and/or an ASIC may be configured and/or structured to perform third operation(s)/function(s) corresponding to a third portion of the machine readable instructions represented by the flowcharts of FIGS. 7-9.

It should be understood that some or all of the circuitry of FIG. 6 may, thus, be instantiated at the same or different times. For example, same and/or different portion(s) of the microprocessor 1100 of FIG. 11 may be programmed to execute portion(s) of machine-readable instructions at the same and/or different times. In some examples, same and/or different portion(s) of the FPGA circuitry 1200 of FIG. 12 may be configured and/or structured to perform operations/functions corresponding to portion(s) of machine-readable instructions at the same and/or different times.

In some examples, some or all of the circuitry of FIG. 6 may be instantiated, for example, in one or more threads executing concurrently and/or in series. For example, the microprocessor 1100 of FIG. 11 may execute machine readable instructions in one or more threads executing concurrently and/or in series. In some examples, the FPGA circuitry 1200 of FIG. 12 may be configured and/or structured to carry out operations/functions concurrently and/or in series. Moreover, in some examples, some or all of the circuitry of FIG. 6 may be implemented within one or more virtual machines and/or containers executing on the microprocessor 1100 of FIG. 11.

In some examples, the programmable circuitry 1012 of FIG. 10 may be in one or more packages. For example, the microprocessor 1100 of FIG. 11 and/or the FPGA circuitry 1200 of FIG. 12 may be in one or more packages. In some examples, an XPU may be implemented by the programmable circuitry 1012 of FIG. 10, which may be in one or more packages. For example, the XPU may include a CPU (e.g., the microprocessor 1100 of FIG. 11, the CPU 1220 of FIG. 12, etc.) in one package, a DSP (e.g., the DSP 1222 of FIG. 12) in another package, a GPU in yet another package, and an FPGA (e.g., the FPGA circuitry 1200 of FIG. 12) in still yet another package.

A block diagram illustrating an example software distribution platform 1305 to distribute software such as the example machine readable instructions 1032 of FIG. 10 to other hardware devices (e.g., hardware devices owned and/or operated by third parties from the owner and/or operator of the software distribution platform) is illustrated in FIG. 13. The example software distribution platform 1305 may be implemented by any computer server, data facility, cloud service, etc., capable of storing and transmitting software to other computing devices. The third parties may be customers of the entity owning and/or operating the software distribution platform 1305. For example, the entity that owns and/or operates the software distribution platform 1305 may be a developer, a seller, and/or a licensor of software such as the example machine readable instructions 1032 of FIG. 10. The third parties may be consumers, users, retailers, OEMs, etc., who purchase and/or license the software for use and/or re-sale and/or sub-licensing. In the illustrated example, the software distribution platform 1305 includes one or more servers and one or more storage devices. The storage devices store the machine readable instructions 1032, which may correspond to the example machine readable instructions of FIGS. 7-9, as described above. The one or more servers of the example software distribution platform 1305 are in communication with an example network 1310, which may correspond to any one or more of the Internet and/or any of the example networks described above. In some examples, the one or more servers are responsive to requests to transmit the software to a requesting party as part of a commercial transaction. Payment for the delivery, sale, and/or license of the software may be handled by the one or more servers of the software distribution platform and/or by a third party payment entity. The servers enable purchasers and/or licensors to download the machine readable instructions 1032 from the software distribution platform 1305. For example, the software, which may correspond to the example machine readable instructions of FIG. 7-9, may be downloaded to the example programmable circuitry platform 1000, which is to execute the machine readable instructions 1032 to implement the defect detection circuitry 320. In some examples, one or more servers of the software distribution platform 1305 periodically offer, transmit, and/or force updates to the software (e.g., the example machine readable instructions 1032 of FIG. 10) to ensure improvements, patches, updates, etc., are distributed and applied to the software at the end user devices. Although referred to as software above, the distributed "software" could alternatively be firmware.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that improve inspection techniques for integrated circuits with backside power delivery by achieving single bit resolution imaging of SRAM cells on an integrated circuit with backside power delivery. Disclosed systems, apparatus, articles of manufacture, and methods improve the efficiency of using a computing device by implementing a defect detection apparatus that achieves single bit resolution imaging of SRAM cells on an integrated circuit to enable detection of defects in an integrated circuit. Disclosed systems, apparatus, articles of manufacture, and methods are accordingly directed to one or more improvement(s) in the operation of a machine such as a computer or other electronic and/or mechanical device.

Example methods, apparatus, systems, and articles of manufacture to improve inspection techniques for integrated circuits are disclosed herein. Further examples and combinations thereof include the following: Example 1 includes an apparatus comprising interface circuitry, machine readable instructions , and at least one programmable circuit to at least one of instantiate or execute the machine readable instructions to modulate first and second bitlines for a bitcell in a memory array of an integrated circuit between first and second voltages at a frequency for a period of time, the modulating of the first and second bitlines to produce a periodic heat signal in the integrated circuit, cause a thermal imaging sensor to capture a series of images of the integrated circuit during the period of time, and determine a location of a defect in the integrated circuit based on the series of images.

Example 2 includes the apparatus of example 1, wherein the second voltage is greater than the first voltage, and the first voltage is greater than 0 volts.

Example 3 includes the apparatus of example 2, wherein the first voltage is approximately 0.6 volts and second voltage is approximately 1.6 volts.

Example 4 includes the apparatus of any one of examples 1-3, wherein the frequency is between 1 hertz and 100 hertz.

Example 5 includes the apparatus of any one of examples 1-4, wherein thermal emissions from the bitcell are associated with a first temperature when the first and second bitlines are modulated to the first voltage and are associated with a second temperature when the first and second bitlines are modulated to the second voltage, a difference between the between the first and second temperatures between 0.5 and 1.0 Kelvin.

Example 6 includes the apparatus of any one of examples 1-5, wherein the defect has a size that is equal to or less than 0.2 micrometers.

Example 7 includes the apparatus of any one of examples 1-6, wherein one or more of the at least one programmable circuit is to determine the location of the defect within a precision of 200 nanometers.

Example 8 includes the apparatus of any one of examples 1-7, wherein one or more of the at least one programmable circuit is to determine the location of the defect by identifying a region of the integrated circuit where thermal emissions from the integrated circuit captured in the series of images are out of phase with the periodic heat signal.

Example 9 includes the apparatus of example 8, wherein the integrated circuit is a first integrated circuit and the thermal emissions are first thermal emissions, one or more of the at least one programmable circuit is to cause the thermal imaging sensor to capture reference thermal emissions from a known good integrated circuit, the known good circuit different than the first integrated circuit and estimate a z-height of the defect within the first integrated circuit based on a comparison of a phase shift of the first thermal emissions to the reference thermal emissions.

Example 10 includes the apparatus of any one of examples 1-9, wherein the integrated circuit includes a backside power delivery architecture with metal layers on both sides of a transistor layer in the integrated circuit.

Example 11 includes the apparatus of any one of examples 1-10, wherein the bitcell is a first bitcell of a plurality of bitcells in the memory array, one or more of the at least one programmable circuit to identify the first bitcell based on a low yield analysis of the plurality of bitcells.

Example 12 includes the apparatus of any one of examples 1-11, wherein one or more of the at least one programmable circuit is to bias the bitcell to an initial state prior the modulating of the first and second bitlines, the initial state corresponding to a logic 0 state, the biasing of the bitcell including turning on a wordline electrically coupled to first and second past gate transistors of the bitcell, controlling the first bitline to 0 volts, and controlling the second bitline to the first voltage, the first voltage greater than 0 volts.

Example 13 includes a non-transitory machine readable storage medium comprising instructions to cause programmable circuitry to at least modulate first and second bitlines for a bitcell in a memory array of an integrated circuit between first and second voltages at a frequency for a period of time, the modulating of the first and second bitlines to produce a periodic heat signal in the integrated circuit, cause a thermal imaging sensor to capture a series of images of the integrated circuit during the period of time, and determine a location of a defect in the integrated circuit based on the series of images.

Example 14 includes the non-transitory machine readable storage medium of example 13, wherein the second voltage is greater than the first voltage, and the first voltage is greater than 0 volts.

Example 15 includes the non-transitory machine readable storage medium of any one of examples 13-14, wherein the frequency is between 1 hertz and 100 hertz.

Example 16 includes the non-transitory machine readable storage medium of any one of examples 13-15, wherein determining the location of the defect includes instructions to cause the programmable circuitry to identify a region of the integrated circuit where thermal emissions from the integrated circuit captured in the series of images are out of phase with the periodic heat signal.

Example 17 includes the non-transitory machine readable storage medium of example 16, wherein the integrated circuit is a first integrated circuit and the thermal emissions are first thermal emissions, the instructions causing the programmable circuitry to cause the thermal imaging sensor to capture reference thermal emissions from a known good integrated circuit, and estimate a z-height of the defect within the first integrated circuit based on a comparison of a phase shift of the first thermal emissions to the reference thermal emissions.

Example 18 includes a method comprising modulating first and second bitlines for a bitcell in a memory array of an integrated circuit between first and second voltages at a frequency for a period of time, the modulating of the first and second bitlines to produce a periodic heat signal in the integrated circuit, capturing, with a thermal imaging sensor, a series of images of the integrated circuit during the period of time, and determining, by executing instructions with at least one programmable circuit, a location of a defect in the integrated circuit based on the series of images.

Example 19 includes the method of example 18, wherein determining the location of the defect includes identifying a region of the integrated circuit where thermal emissions from the integrated circuit captured in the series of images are out of phase with the periodic heat signal.

Example 20 includes the method of example 19, wherein the integrated circuit is a first integrated circuit, and the thermal emissions are first thermal emissions, the method further including capturing reference thermal emissions from a known good integrated circuit, and estimating a z-height of the defect within the first integrated circuit based on a comparison of a phase shift of the first thermal emissions to the reference thermal emissions.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. A method comprising:
modulating first and second bitlines for a bitcell in a memory array of an integrated circuit between first and second voltages at a frequency for a period of time, the modulating of the first and second bitlines to produce a periodic heat signal in the integrated circuit;
capturing, with a thermal imaging sensor, a series of images of the integrated circuit during the period of time; and
determining a location of a defect in the integrated circuit based on the series of images.

2. The method of claim 1, wherein the second voltage is greater than the first voltage, and the first voltage is greater than 0 volts.

3. The method of claim 2, wherein the first voltage is approximately 0.6 volts and second voltage is approximately 1.6 volts.

4. The method of any one of claims 1-3, wherein the frequency is between 1 hertz and 100 hertz.

5. The method of any one of claims 1-4, wherein thermal emissions from the bitcell are associated with a first temperature when the first and second bitlines are modulated to the first voltage and are associated with a second temperature when the first and second bitlines are modulated to the second voltage, a difference between the first and second temperatures between 0.5 and 1.0 Kelvin.

6. The method of any one of claims 1-5, wherein the defect has a size that is equal to or less than 0.2 micrometers.

7. The method of any one of claims 1-6, further including determining the location of the defect within a precision of 200 nanometers.

8. The method of any one of claims 1-7, further including determining the location of the defect by identifying a region of the integrated circuit where thermal emissions from the integrated circuit captured in the series of images are out of phase with the periodic heat signal.

9. The method of claim 8, wherein the integrated circuit is a first integrated circuit and the thermal emissions are first thermal emissions, the method further including:
capturing reference thermal emissions from a known good integrated circuit, the known good integrated circuit different than the first integrated circuit; and
estimating a z-height of the defect within the first integrated circuit based on a comparison of a phase shift of the first thermal emissions to the reference thermal emissions.

10. The method of any one of claims 1-9, wherein the integrated circuit includes a backside power delivery architecture with metal layers on both sides of a transistor layer in the integrated circuit.

11. The method of any one of claims 1-10, wherein the bitcell is a first bitcell of a plurality of bitcells in the memory array, the method further including identifying the first bitcell based on a low yield analysis of the plurality of bitcells.

12. The method of any one of claims 1-11, further including biasing the bitcell to an initial state prior to modulating the first and second bitlines, the initial state corresponding to a logic 0 state, the biasing of the bitcell including:
turning on a wordline electrically coupled to first and second pass gate transistors of the bitcell;
controlling the first bitline to 0 volts; and
controlling the second bitline to the first voltage, the first voltage greater than 0 volts.

13. An apparatus comprising means to perform a method as claimed in any preceding claim.

14. Machine-readable storage including machine-readable instructions, when executed, to implement a method or realize an apparatus as claimed in any preceding claim.
